Europäisches Patentamt

European Patent Office

Office européen des brevets

(11) Publication number: **0 281 404**
**A2**

# (12) EUROPEAN PATENT APPLICATION

(21) Application number: **88301881.4**

(22) Date of filing: **03.03.88**

(51) Int. Cl.⁴: **H 05 K 7/20**

(30) Priority: **04.03.87 JP 47645/87**
**10.11.87 JP 283890/87**

(43) Date of publication of application:
**07.09.88 Bulletin 88/36**

(84) Designated Contracting States: **DE FR GB**

(71) Applicant: **NEC CORPORATION**
**33-1, Shiba 5-chome, Minato-ku**
**Tokyo 108 (JP)**

(72) Inventor: **Matsuo, Youichi c/o NEC Corporation**
**33-1, Shiba 5-chome**
**Minato-ku Tokyo (JP)**

**Mizuno, Tsukasa c/o NEC Corporation**
**33-1, Shiba 5-chome**
**Minato-ku Tokyo (JP)**

(74) Representative: **Pears, David Ashley et al**
**REDDIE & GROSE 16 Theobalds Road**
**London WC1X 8PL (GB)**

(54) Cooling system for electronic equipment.

(57) A cooling system for electronic equipment includes a cooling pipe (50) through which a coolant flows, a heat dissipation plate (36) connected to the cooling pipe, a sheet (35) which has a high heat conductivity and is in surface contact with the heat dissipation plate, and a plurality of IC elements (33) mounted on the sheet (35) having a high heat conductivity.

FIG.5

EP 0 281 404 A2

# Description

## Cooling System for Electronic Equipment

The present invention relates to a cooling system for electronic equipment such as a computer.

A packing density of IC elements themselves and a mounting density of these IC elements on circuit boards have been recently increased to provide compact equipment in electronic equipment such as a computer. Along with this, cooling of the electronic equipment as a whole has become an important problem.

A typical conventional cooling system for electronic equipment is disclosed in United States Patent No. 4,158,875.

Conventional cooling systems for various types of electronic equipment are based on cooling with air by using fans in principle. The cooling capacities of these cooling system are too low to satisfy requirements of recent electronic equipment. In addition, the conventional cooling systems are bulky and noisy and fail to provide compact, low-noise cooling systems.

## Summary of the Invention

It is an object of the present invention to eliminate the conventional drawbacks and to provide a compact, simple cooling system which is capable of efficiently cooling electronic equipment having elements mounted in a high density and is free from noise generated by a fan.

A cooling system for electronic equipment according to the present invention comprises a cooling pipe through which a coolant flows, a heat dissipation plate connected to the cooling pipe, a plate which has a high heat conductivity and is in surface contact with the heat dissipation plate, and a plurality of IC elements mounted so as to contact with the plate having a high heat conductivity.

## Brief Description of the Drawings

Fig. 1 is a partial cutaway perspective view of a structure according to an embodiment of the present invention;

Figs. 2 and 3 are a plan view and a front view, respectively, showing the detailed structure of the main part of the embodiment shown in Fig. 1;

Fig. 4 is a view for explaining the operation of the embodiment shown in Fig. 1;

Fig. 5 is a partial exploded perspective view showing a structure according to another embodiment of the present invention;

Figs. 6 and 7 are sectional views of the structure shown in Fig. 5 taken along the lines A and B therein, respectively; and

Fig. 8 is a perspective view showing a structure of a fixing portion in Fig. 5.

## Detailed Description of the Preferred Embodiments

Preferred embodiments of the present invention will be described in detail with reference to the accompanying drawings.

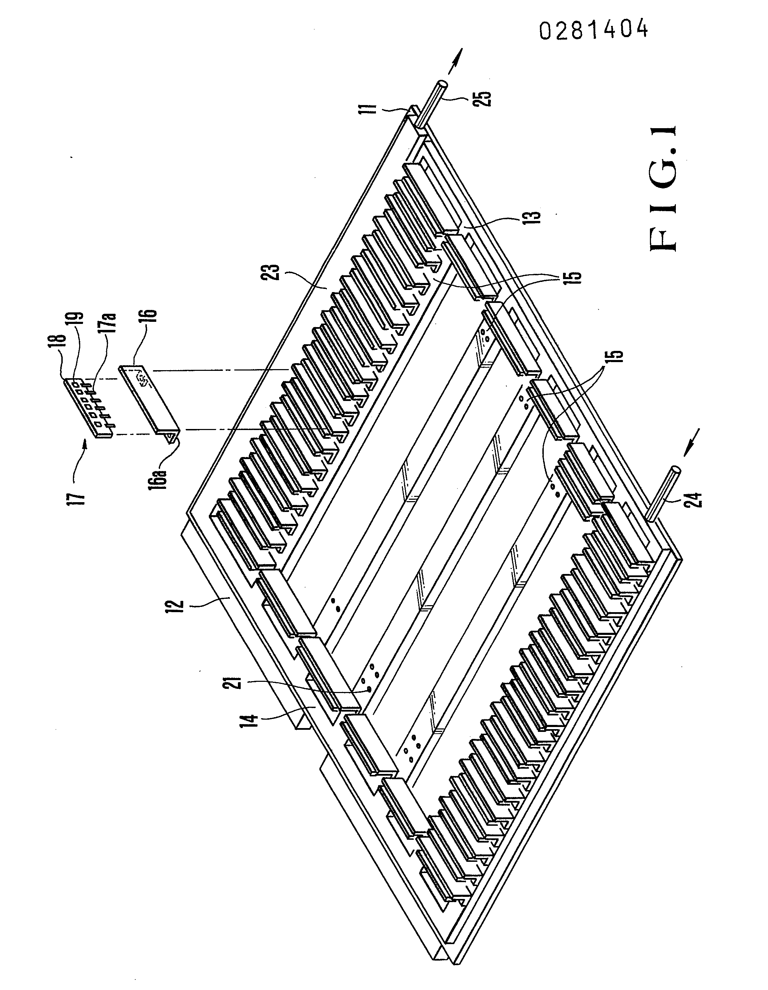

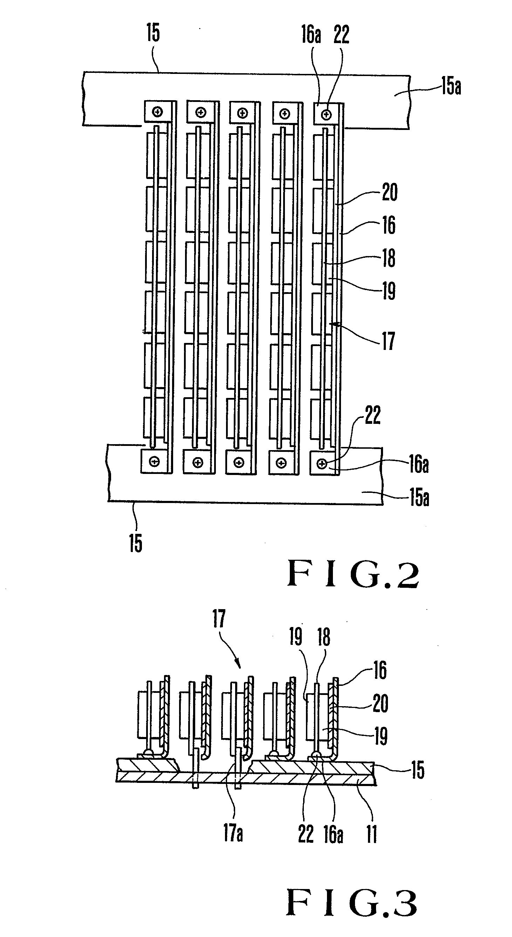

Figs. 1, 2, and 3 are a perspective view, a plan view, and a front view, respectively, showing a cooling system for electronic equipment according to an embodiment of the present invention. Referring to Figs. 1, 2, and 3, reference numeral 11 denotes a circuit board having a connector 12. A supply header 13 and a return header 14 which serve as coolant paths are formed at both edges of the circuit board 11, respectively. Reference numerals 15 denote a large number of cooling pipes each having an upper flat surface 15a. The cooling pipes 15 are disposed on the circuit board 11 at predetermined intervals and are connected to each other so as to extend in a direction perpendicular to the supply and return headers 13 and 14. Reference numeral 16 denotes a cooling plate made of a metal having a high heat conductivity. Each cooling plate 16 is supported by adjacent cooling pipes 15 and extends upright on the circuit board 11. A portion 16a of the cooling plate 16 which is in contact with the flat surface 15a of the corresponding cooling pipe 15 is bent. Reference numeral 17 denotes a semiconductor module having a large number of leads 17a extending from one side. A large number of IC elements 19 are mounted on a ceramic SIP substrate 18. Each semiconductor module 17 is arranged near the corresponding cooling plate 16 and is soldered between the adjacent cooling pipes 15. Reference numeral 20 denotes a heat dissipation sheet made of a rubber elastic member having a high heat conductivity. Each heat dissipation sheet 20 is interposed between the corresponding semiconductor module 17 and the corresponding cooling plate 16. The sheets 20 are partially in tight contact with the corresponding IC elements 19, so that variations in height of the IC elements 19 are absorbed by the heat dissipation sheets 20. Reference numerals 21 denote screw holes which are threadably engaged with screws 22 for fixing each cooling plate 16; 23, a return pipe connected to the return header 14; and 24 and 25, a supply port and a return port, respectively.

In the cooling system for IC elements as described above, the IC elements 19 can be cooled by the cooling pipes 15 through the cooling plates 16 and the heat dissipation sheets 20.

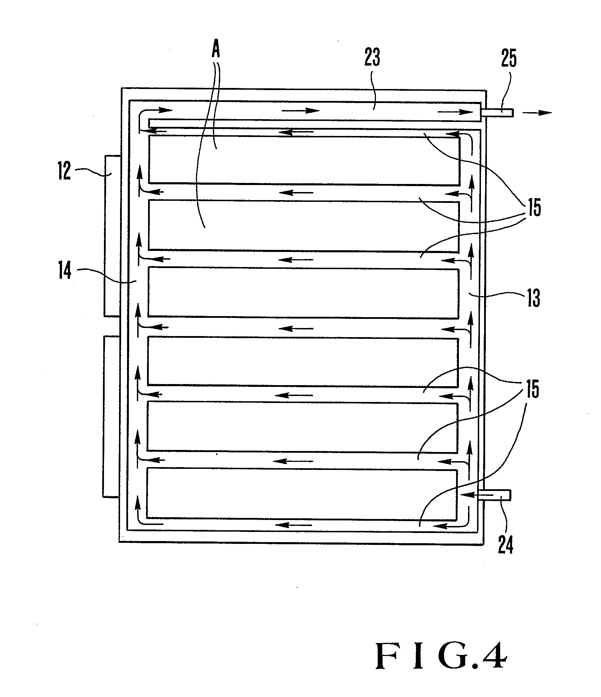

Fig. 4 shows the behavior of the coolant when the cooling system of this embodiment is actually used. Heat generated by the IC elements 19 is conducted to the coolant in the cooling pipes 15 through the heat dissipation sheets 20 and the cooling plates 16 since the coolant such as Freon supplied from the supply port 24 to the supply header 13 flows through the cooling pipes 15, as indicated by arrows in Fig. 4. In this manner, heat can be dissipated. Reference symbols A in Fig. 4 denote mounting areas of the semiconductor modules 17 on the circuit board 11.

In this embodiment, since the heat dissipation sheets 20 and the cooling plates 16 are made of a material having a high heat conductivity, the thermal resistance of the heat conduction paths can be minimized.

In this embodiment, Freon is used as a coolant. However, the coolant is not limited to Freon but can be replaced with cooling water.

In the above embodiment, the heat dissipation sheet which is partially in tight contact with the IC elements is interposed between the corresponding semiconductor module and cooling plate. Therefore, the IC elements can be cooled by heat conduction. The cooling capacity can be greatly improved as compared with cooling with air. The mounting density of IC elements on a circuit board can be increased. Since a large fan as in the conventional cooling system is not used, no noise is produced while the IC elements are cooled. In addition, a housing for the cooling system can be made compact.

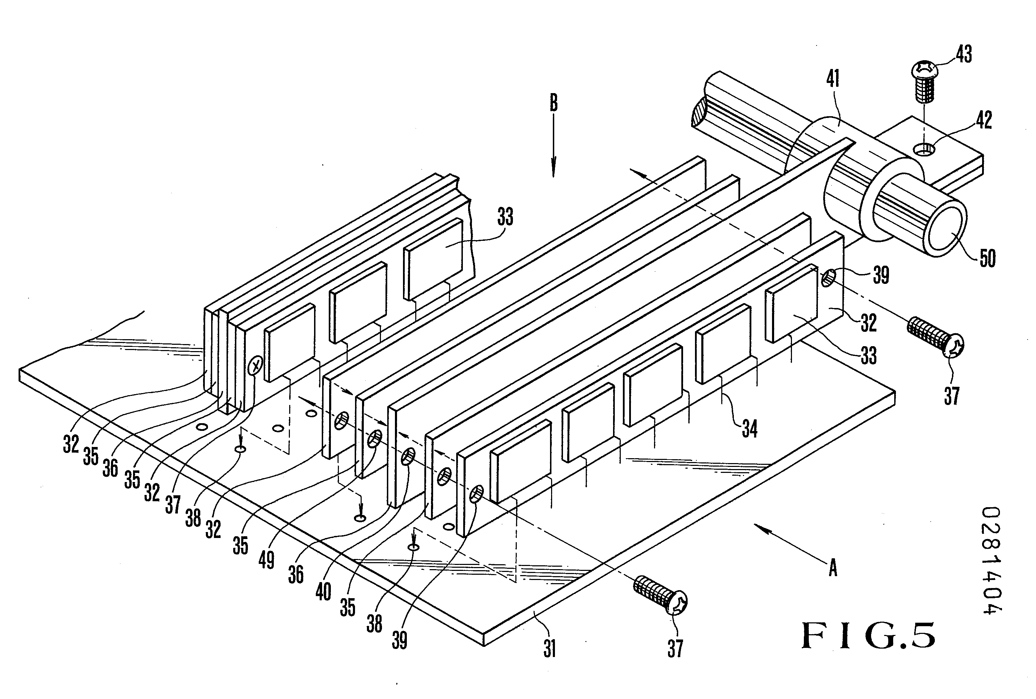

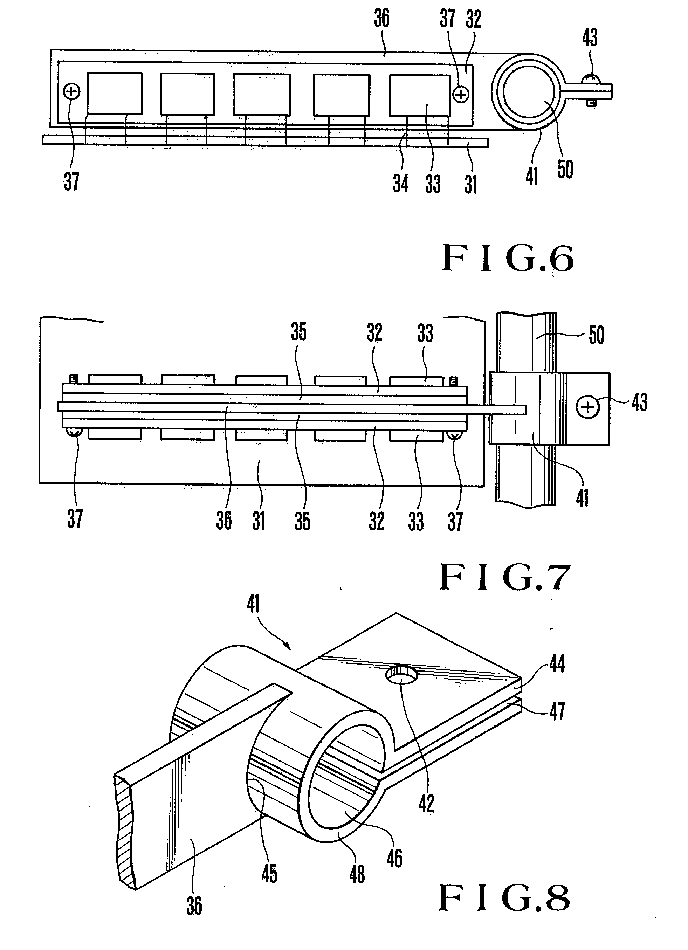

Fig. 5 is a partial exploded perspective view showing part of a cooling system for electronic equipment according to another embodiment of the present invention, and Figs. 6 and 7 are sectional views thereof taken along the lines A and B in Fig. 5.

Referring to Figs. 5, 6, and 7, reference numeral 31 denotes a printed circuit board; 32, two SIP substrates having screw holes 39 at both ends thereof; 33, LCC elements mounted on one side surface of each SIP board 32; 34, pins for connecting each LCC element with wirings of the circuit board 31; 35, sheets having the same size as that of the SIP board 32 and screw holes 49 at both ends thereof and made of a material of high elasticity and high heat conductivity; and 36, a heat dissipation plate having a screw hole 40 at each of the front and rear ends. The rear end of the heat dissipation plate is brazed to a fixing portion 41. Reference numeral 38 denotes a through hole formed at a circuit board position corresponding to each pin 34; and 50, a pipe through which a coolant flows.

As shown in Fig. 8, the fixing portion 41 comprises a slightly elastic cylindrical portion 48 and flat portions 44 having screw holes 42. The fixing portion 41 is jointed to the heat dissipation plate 36 by a brazed portion 45. A gap 47 is formed between the flat portions 44 before a screw 43 is engaged with the screw holes 42.

Two conductive sheets 35 are brought into contact with the heat dissipation plate 36 so as to sandwich the plate 36. The SIP boards 32 are respectively brought into contact with the outer surfaces of the conductive sheets 35 such that the SIP board surfaces having no LCC elements 33 face inward. The heat dissipation plate 36, the conductive sheets 35, and the SIP boards 32 are integrally fixed by screws 37 engaged with the screw holes 39, 49, and 40. Therefore, the two SIP boards 32 are in tight contact with one heat dissipation plate 36 through the conductive sheets 35. In this state, each pin 34 on the SIP board 32 is inserted in the corresponding through hole 38. Signal input/output between the printed circuit board 31 and the LCC elements 33 and the supply of power from the printed circuit board 31 to the LCC elements 33 are performed. The pipe 50 through which the coolant flows is fixed to the fixing portion 41 of the heat dissipation plate 36. The pipe 50 is fitted in a hollow portion 46 of the cylindrical portion 48 and is fastened by the screw 43 through the screw holes 42.

The operation of this embodiment will be described below.

Heat generated by each LCC element 33 is conducted from the element 33 to the SIP board 32 and is transmitted to the heat dissipation plate 36 from the LCC element mounting surface of the SIP substrate 32 through the conductive sheet 35. This heat is further conducted to the fixing portion 41 at the rear end of the heat dissipation plate 36 and reaches the pipe 50. The heat is then conducted to the coolant flowing through the pipe 50 and is dissipated, thereby cooling the LCC element 33.

As described above, the cooling structure for the IC according to the present invention is given such that the SIP assemblies are in tight contact with the heat dissipation plate through the corresponding members made of a material having a high heat conductivity. The cooling capacity can be greatly increased as compared with conventional cooling with air. Therefore, the temperature of each element in a highly integrated equipment using IC circuits can be sufficiently kept low.

## Claims

1. A cooling system for electronic equipment, comprising:
   a cooling pipe through which a coolant flows;
   a heat dissipation plate connected to said cooling pipe;
   a plate brought into surface contact with said heat dissipation plate and having a high heat conductivity; and
   a plurality of IC elements mounted so as to contact with said plate having the high thermal conductivity.

2. A system according to claim 1, wherein said heat dissipation plate is supported upright by at least two cooling pipes.

3. A system according to claim 1, wherein said heat dissipation plate is supported having an end fixed to said cooling pipe.

4. A cooling system for IC elements, comprising:
   at least two cooling pipes mounted on a circuit board and spaced apart from each other at a predetermined interval;
   a cooling plate supported by said at least two cooling pipes and extending upright on said circuit board;
   a semiconductor module mounted arranged near said cooling plate between said cooling pipes and having a large number of IC elements; and
   a heat dissipation sheet interposed between said semiconductor module and said cooling plate to be in tight contact with part of said semiconductor module.

5. A cooling system for IC elements, comprising an SIP assembly including the IC elements on one surface thereof and mounted on a

F I G. 1

02814U4

0281404

FIG.2

FIG.3

**FIG.4**

F I G.5

0281404

0281404

FIG.6

FIG.7

FIG.8